# EUROPEAN PATENT APPLICATION

(11) **EP 4 252 564 A1**
(43) Date of publication of application: **04.10.2023**
(21) Application number: 21896784.2
(22) Date of filing: 10.11.2021
(51) Int. Cl.: A24F 40/40, A24F 40/50, A24F 40/51, A24F 40/60, A24F 47/00, G06F 3/044

(54) **BATTERY ROD FOR ELECTRONIC ATOMIZATION AND ELECTRONIC ATOMIZATION DEVICE**

(30) Priority: 24.11.2020 CN 202011331071
(71) Applicant: Shenzhen Smoore Technology Limited, Shenzhen, Guangdong 518102 (CN)
(72) Inventor: TAN, Hua, Shenzhen, Guangdong 518102 (CN); XIE, Zhengjun, Shenzhen, Guangdong 518102 (CN); CHEN, Tao, Shenzhen, Guangdong 518102 (CN); YE, Xiaowei, Shenzhen, Guangdong 518102 (CN); ZENG, Zhaohuan, Shenzhen, Guangdong 518102 (CN)
(74) Representative: De Arpe Tejero, Manuel
(86) International application number: PCT/CN2021/129868
(87) International publication number: WO 2022/111283

(57) **Abstract**

A battery rod (42) for electronic atomization and an electronic atomization device (40), the battery rod (42) comprising: a housing (11), a touch area (12) being provided on the housing (11), and the touch area (12) being conductive; a touch sensing electrode (13), which is located within the housing (11) and which is arranged corresponding to the touch area (12), the touch area (12) forming an inductive capacitance with the touch sensing electrode (13); and a control chip (14), which is located within the housing (11), connected to the touch sensing electrode (13), and used for detecting a capacitance value of the inductive capacitance and generating a control instruction when a change in the capacitance value of the inductive capacitance is detected, so as to control the battery rod (42) to perform a corresponding operation. A single-point touch by the battery rod (42) is achieved without separately providing a touch panel, achieving a small volume and reducing costs.

## Description

### CROSS REFERENCE TO RELATED APPLICATIONS

The present disclosure claims priority to Chinese patent application NO. 202011331071.1 filed on November 24, 2020, the entire contents of which are herein incorporated by reference in its entirety.

### TECHNICAL FIELD

The present disclosure relates to the technical field of atomization, in particular to a battery rod for electronic atomization and an electronic atomization device.

### BACKGROUND

In order to achieve a single-point control scheme, the existing electronic atomization device usually includes a physical key, an air pressure sensor, or a touch sensor. However, in case that the physical key is provided in the electronic atomization device, the miniaturization design of the electronic atomization device is hard to achieve due to the large size of the key. In case that the air pressure sensor is provided in the electronic atomization device, since the external pressure of the air pressure sensor is not a fixed value, the detect chip is prone to misjudge. In case that the touch sensor is provided in the electronic atomization device, an independent touch panel is needed, which is large in size, such that the cost is high, and the difficulty of assembly and design is increased.

### SUMMARY

The present disclosure provides a battery rod for electronic atomization and an electronic atomization device. The battery rod and the electronic atomization device are configured to realize the single-point touch scheme of the battery rod and do not need to arrange a touch panel independently, such that the small size may be achieved and the cost is reduced.

To solve the above technical problem, the first technical scheme provided by the present disclosure is to provide a battery rod for the electronic atomization. The battery rod is configured to cooperate with an atomizer to realize the electronic atomization. The battery rod includes: a housing, having a touch region, and the touch region being conductive; at least one touch sensing electrode, located in the housing and arranged facing the touch region, the touch region and the at least one touch sensing electrode forming an inductive capacitor cooperatively; a control chip, located in the housing, connected to the at least one touch sensing electrode, and configured to detect the capacitance value of the inductive capacitor and control the operations of the battery rod according to the change of the detected capacitance value of the inductive capacitor.

In some embodiments, the housing is made of a metal material, and the touch region is a portion of the outer surface of the housing facing the at least one touch sensing electrode.

In some embodiments, the housing includes an insulative shell and a conductive layer arranged on the outer surface of the insulative shell, and the conductive layer is corresponding to the touch region.

In some embodiments, the housing includes an insulative shell, a conductive layer arranged on the outer surface of the insulative shell, and a conductive layer arranged on the inner surface of the insulative shell; the conductive layer arranged on the outer surface of the insulative shell and the conductive layer arranged on the inner surface of the insulative shell are corresponding to the touch region; and the conductive layer arranged on the inner surface of the insulative shell serves as the at least one touch sensing electrode.

In some embodiments, the at least one touch sensing electrode is spaced apart from the touch region.

In some embodiments, the battery rod further includes: a circuit board, located in and insulated from the housing, and at least one selected from the group consisting of the at least one touch sensing electrode and the control chip being integrated on the circuit board.

In some embodiments, the at least one touch sensing electrode includes a metal pad.

In some embodiments, the at least one touch sensing electrode includes at least two touch sensing electrodes.

In some embodiments, the battery rod is configured in such a way that the capacitance value of the inductive capacitor is changeable as the touch region is touched.

To solve the above technical problem, the second technical scheme provided by the present disclosure is to provide an electronic atomization device. The electronic atomization device, includes an atomizer and the battery rod described above. The battery rod is configured to supply power to the atomizer.

Beneficial effects of the present disclosure are as follows. The battery rod provided by some embodiments of the present disclosure includes: a housing, having a touch region, and the touch region being conductive; at least one touch sensing electrode, located in the housing and arranged facing the touch region, the touch region and the at least one touch sensing electrode forming an inductive capacitor cooperatively; a control chip, located in the housing, connected to the at least one touch sensing electrode, and configured to detect the capacitance value of the inductive capacitor and control the operations of the battery rod according to the change of the detected capacitance value of the inductive capacitor. In this way, the single-point control scheme of the battery rod may be realized, the battery rod does not need an independent touch panel, the small size may be achieved, and the cost may be reduced.

### BRIEF DESCRIPTION OF THE DRAWINGS

FIG. 1 is a structural schematic view of a battery rod according to some embodiments of the present disclosure.
FIG. 2 is a structural schematic view of the battery rod according to some embodiments of the present disclosure.
FIG. 3 is a structural schematic view of the battery rod according to some embodiments of the present disclosure.
FIG. 4 is a structural schematic view of an electronic atomization device according to some embodiments of the present disclosure.

### DETAILED DESCRIPTIONS

The technical solutions in the embodiments of the present disclosure will be described clearly and completely with reference to the figures in the embodiments of the present disclosure. Obviously, the described embodiments are only a part of the embodiments of the present disclosure, rather than all of them. Based on the embodiments of the present disclosure, all other embodiments obtained by those skilled in the art without any creative work are within the scope of the present disclosure.

In the following descriptions, specific details, such as specific system structure, interface, technology, etc., are proposed for explanation rather than limitation, so as to thoroughly understand the present disclosure.

The term "and/or" in the present disclosure is just a kind of associate relationship describing associate objects, which means that there may be three kinds of relationships. For example, A and/or B may mean that there are three cases: A exists alone, both A and B exist, and B exists alone. In addition, the character "/" in the present disclosure generally indicates that the associate objects before "/" and after "/" have an "or" relationship. In addition, "a plurality of" in the present disclosure means two or more.

The terms "first", "second", and "third" in the embodiments of the present disclosure are only used for descriptive purposes, and cannot be understood as indicating or implying relative importance or implicitly indicating the number of indicated technical features. Thus, the features defined with "first", "second", and "third" may explicitly or implicitly include at least one of the features. In the description of the present disclosure, "a plurality of" means at least two, e. g., two, three, etc., unless specifically defined otherwise. All directional indications (such as up, down, left, right, front, back) in the embodiments of the present disclosure are only used to account for relative positional relationships, motion conditions, etc., between components in a particular orientation (as shown in the drawings), if the particular orientation changes, the directional indications correspondingly change. In addition, the terms "including" and "having" and any variations thereof are intended to cover non-exclusive inclusions. For example, a process, method, system, product, or device that includes a series of steps or units is not limited to the listed steps or units, but optionally includes unlisted steps or units, or optionally also includes other steps or units inherent to the process, method, product or device.

Mentioning "embodiments" herein means that a specific feature, structure, or characteristic described in conjunction with the embodiments may be included in at least one embodiment of the present disclosure. The appearances of the phrase in various places in the specification are not necessarily all referring to the same embodiment, nor are separate or alternative embodiments mutually exclusive of other embodiments. It is explicitly and implicitly understood by those skilled in the art that the embodiments described herein may be combined with other embodiments.

The single-point touch scheme of the existing electronic atomization device may be achieved in three ways. In the first way, a physical key is provided in the electronic atomization device; the electronic atomization device collects the high-level signals and low-level signals and takes corresponding actions according to the collected high-level signals and low-level signals by using the control chip, such as a Microcontroller Unit (MCU). The disadvantage of the first way is that the size of the physical key is too large, the miniaturization design of the electronic atomization device is hard to achieve, the cost is relatively high, and the integrated design is hard to achieve. In the second way, an air pressure sensor is provided in the electronic atomization device; the electronic atomization device collects the change of the output of the air pressure sensor and makes judgments by using the control chip, such as an MCU. However, the external air pressure is not a stable value, and may change when the wind blows, which leads to the misjudgment of the MCU, such that the suction taste is affected. In the third way, a touch sensor and a touch panel are provided in the electronic atomization device; the electronic atomization device collects the signals of the touch panel by using the touch sensor, so as to output the variation to the control chip, such as an MCU; the control chip outputs a control instruction, such that the electronic atomization device may take the action corresponding to the control instruction. However, in the third way, the matching touch panel is needed, such that the cost is high, and the difficulty of design is increased. Some embodiments of the present disclosure provide a battery rod, which may realize the single-point touch scheme of the battery rod. The battery rod does not need an independent touch panel, such that the small size may be achieved, and the purpose of reducing the cost may be achieved. The following is a detailed description in combination with the figures and some embodiments.

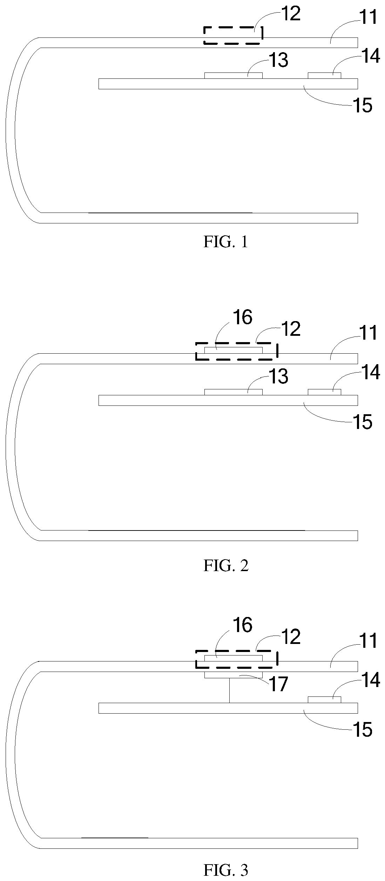

As shown in FIG. 1, FIG. 1 is a structural schematic view of a battery rod according to some embodiments of the present disclosure. The battery rod includes a housing 11. The housing has a touch region 12. The touch region 12 includes a conductive material. The battery rod also includes a touch sensing electrode 13. The touch sensing electrode 13 is located in the housing 11 and arranged facing the touch region 12. The touch region 12 and the touch sensing electrode 13 form an inductive capacitor cooperatively. The battery rod also includes a control chip 14. The control chip 14 is located in the housing 11, connected to the touch sensing electrode 13, and configured to detect the capacitance value of the inductive capacitor, generate a control instruction as the detected capacitance value of the inductive capacitor changes, and control the operations of the battery rod.

In some embodiments, the housing 11 is made of a conductive material as a whole. For example, the housing 11 may be made of a metal material or other conductive plastic materials. In some embodiments, the housing 11 is made of a metal material. The material of the touch region 12 is the same as the material of other portions of the housing 11. The touch region 12 is a portion of the outer surface of the housing 11 facing the touch sensing electrode13.

In some embodiments, the projection of the touch region 12 in the vertical direction and the projection of the touch sensing electrode 13 in the vertical direction are completely overlapped with each other; in some embodiments, the projection of the touch region 12 in the vertical direction covers the projection of the touch sensing electrode 13 in the vertical direction; in some embodiments, the projection of the touch region 12 in the vertical direction falls in the projection of the touch sensing electrode 13 in the vertical direction, which is not limited herein.

It can be understood that, in order to form an inductive capacitor between the touch region 12 and the touch sensing electrode 13, the touch region 12 is required to be insulated from the touch sensing electrode 13, that is, the touch region 12 may be spaced apart from the touch sensing electrode 13. In some embodiments, the touch region 12 and the touch sensing electrode 13 are spaced apart from each other through air, that is, the touch region 12 and the touch sensing electrode 13 are not in contact with each other, but are insulated through the air. In some embodiments, an insulative layer may also be arranged between the touch region 12 and the touch sensing electrode 13, that is, the touch region 12 and the touch sensing electrode 13 are spaced apart from each other through the insulative layer, such that the insulation may be achieved.

In some embodiments, the touch sensing electrode 13 may be a conductive sheet independent from the housing 11. The touch sensing electrode 13 may be arranged in the housing 11 and insulated from the housing 11, as long as the touch sensing electrode 13 may cooperate with the conductive housing 11 to form a capacitor.

In some embodiments, the battery rod may also include a circuit board 15. The circuit board 15 is located in the housing 11 and insulated from the housing 11. At least one selected from the group consisting of the touch sensing electrode 13 and the control chip 14 is integrated on the circuit board 15, as shown in FIG. 1. In some embodiments, the touch sensing electrode 13 is connected to the control chip 14 through the circuit structure of the circuit board 15, such that the control chip 14 may detect the capacitance value of the inductive capacitor. In some embodiments, the circuit board 15 may be a flexible circuit board, a printed circuit board, etc., which is not limited herein. The control chip 14 may be an MCU.

In some embodiments, the touch sensing electrode 13 may be a metal pad arranged on the circuit board 15. The touch sensing electrode 13 may be a one-piece component, and may be circle-shaped, square-shaped, trapezoid-shaped, rhomb-shaped, etc., which is not limited herein. In some embodiments, the battery rod may include at least two touch sensing electrodes 13. For example, the battery rod may include a plurality of touch sensing electrodes 13, and the plurality of touch sensing electrodes 13 are electrically connected to each other. For example, a plurality of pads arranged on the circuit board serves as the plurality of touch sensing electrodes 13, and the plurality of pads are electrically connected to each other. In case that the plurality of pads are arranged on the circuit board, the area of the circuit board occupied by the plurality of pads may be reduced compared with the square-shaped pad of the one-piece component, and the area of the circuit board may be reduced.

In the battery rod shown in FIG. 1, as the touch region 12 is touched, the capacitance value of the inductive capacitor changes. As the user uses the battery rod, the user touches the touch region 12, and a voltage is applied to the touch region 12. The control chip 14 may detect that the capacitance value of the inductive capacitor changes, output the control instruction, and control the operations of the battery rod. For example, in case that the battery rod is in a sleep state, as the user holds the touch region 12 of the battery rod, the control chip 14 may detect that the capacitance value changes, output the control instruction, and control the battery rod to enter an open state. In some embodiments, in case that the battery rod is in the open state, as the user holds the touch region 12 of the battery rod, the control chip 14 may detect that the capacitance value changes, output the control instruction, and control the battery rod to enter the sleep state.

The battery rod provided in some embodiments of the present disclosure has the touch region 12 arranged on the housing 11 and the touch sensing electrode 13 arranged in the housing 11, such that the touch region 12 and the touch sensing electrode 13 may form the inductive capacitor cooperatively. The change of the inductive capacitor may be detected by the control chip 14. As it is detected that the inductive capacitor changes, the control chip 14 may output the control instruction and control the operations of the battery rod. In this way, the single-point touch design may be realized. The battery rod does not need an independent touch panel, such that the size is small, the integrated design may be achieved, the assembly difficulty does not exist, the design cost is reduced, and the large-scale production may be achieved.

As shown in FIG. 2, FIG. 2 is a structural schematic view of the battery rod according to some embodiments of the present disclosure. The embodiments shown in FIG. 2 are different from the embodiments shown in FIG. 1 above in that the housing 11 includes an insulative shell 11 and a conductive layer 16 arranged on the outer surface of the insulative shell 11. The conductive layer 16 is corresponding to or disposed in the touch region 12. In some embodiments, the conductive layer 16 is coated on the surface of the insulative shell 11 away from the circuit board 15. In some embodiments, the conductive layer 16 may be a conductive ink or a metal film.

In some embodiments, the touch sensing electrode 13 and the conductive layer 16 disposed in the touch region 12 form an inductive capacitor cooperatively.

As the conductive layer 16 disposed in the touch region 12 is touched, the capacitance value of the inductive capacitor changes. In some embodiments, as the user uses the battery rod, the user touches the conductive layer 16 disposed in the touch region 12, and a voltage is applied to the sensing region 12. The control chip 14 may detect that the capacitance value of the inductive capacitor changes, output the control instruction, and control the operations of the battery rod. For example, in case that the battery rod is in a sleep state, as the user holds the touch region 12 of the battery rod, the control chip 14 may detect that the capacitance value changes, output the control instruction, and control the battery rod to enter an open state. In some embodiments, in case that the battery rod is in the open state, as the user holds the touch region 12 of the battery rod, the control chip 14 may detect that the capacitance value changes, output the control instruction, and control the battery rod to enter the sleep state.

The battery rod provided in the present disclosure has the touch region 12 arranged on the housing 11 and the touch sensing electrode 13 arranged in the housing 11, such that the touch region 12 and the touch sensing electrode 13 may form the inductive capacitor cooperatively. The change of the inductive capacitor may be detected by the control chip 14. As it is detected that the inductive capacitor changes, the control chip 14 may output the control instruction and control the operations of the battery rod. In this way, the single-point touch design may be realized. The battery rod does not need an independent touch panel, such that the size is small, the integrated design may be achieved, the assembly difficulty does not exist, the design cost is reduced, and the large-scale production may be achieved.

As shown in FIG. 3, FIG. 3 is a structural schematic view of the battery rod according to some embodiments of the present disclosure. The embodiments shown in FIG. 3 are different from the embodiments shown in FIG. 1 above in that the housing 11 includes an insulative shell 11, a conductive layer 16 arranged on the outer surface of the insulative shell 11, and a conductive layer 17 arranged on the inner surface of the insulative shell 11. The conductive layer 16 arranged on the outer surface of the insulative shell 11 and the conductive layer 17 arranged on the inner surface of the insulative shell 11 are corresponding to or disposed in the touch region 12. The conductive layer 17 on the inner surface of the insulative shell 11 serves as the touch sensing electrode 13.

In some embodiments, the conductive layer 16 and the conductive layer 17 may be conductive inks.

In some embodiments, the conductive layer 16 and the conductive layer 17 may form an inductive capacitor cooperatively. The control chip 14 is arranged on the circuit board 15. The conductive layer 17 is connected to the circuit structure of the circuit board 15, and further connected to the control chip 14 through the circuit structure of the circuit board 15, such that the control chip 14 may detect the change of the inductive capacitor.

As the conductive layer 16 disposed in the touch region 12 is touched, the capacitance value of the inductive capacitor changes. In some embodiments, as the user uses the battery rod, the user touches the conductive layer 16 disposed in the touch region 12, and a voltage is applied to the sensing region 12. The control chip 14 may detect that the capacitance value of the inductive capacitor changes, output the control instruction, and control the operations of the battery rod. For example, in case that the battery rod is in a sleep state, as the user holds the touch region 12 of the battery rod, the control chip 14 may detect that the capacitance value changes, output the control instruction, and control the battery rod to enter an open state. In some embodiments, in case that the battery rod is in the open state, as the user holds the touch region 12 of the battery rod, the control chip 14 may detect that the capacitance value changes, output the control instruction, and control the battery rod to enter the sleep state.

The battery rod provided in some embodiments of the present disclosure has the touch region 12 arranged on the housing 11 and the touch sensing electrode 13 arranged in the housing 11, such that the touch region 12 and the touch sensing electrode 13 may form the inductive capacitor cooperatively. The change of the inductive capacitor may be detected by the control chip 14. As it is detected that the inductive capacitor changes, the control chip 14 may output the control instruction and control the operations of the battery rod. In this way, the single-point touch design may be realized. The battery rod does not need an independent touch panel, such that the size is small, the integrated design may be achieved, the assembly difficulty does not exist, the design cost is reduced, and the large-scale production may be achieved.

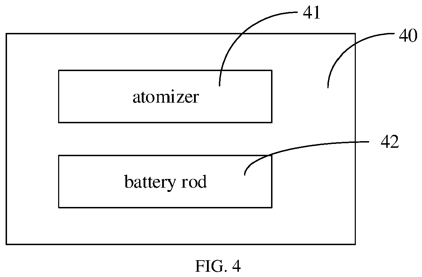

As shown in FIG. 4, FIG. 4 is a structural schematic view of an electronic atomization device according to some embodiments of the present disclosure. The electronic atomization device 40 includes an atomizer 41 and the battery rod 42 described in any one of the above embodiments shown in FIGS. 1-3. The battery rod 42 is configured to supply power to the atomizer 41.

Other structures of the battery rod 42 in some embodiments of the present disclosure are the same as those in the related art, and will not be described herein.

The above description are only embodiments of the present disclosure, and do not limit the scope of the present disclosure. Any equivalent structure or equivalent process transformation made by using the contents of the description and drawings of the present disclosure, or directly or indirectly used in other related technical fields, are similarly included in the scope of patent protection of the present disclosure.

## Claims

1. A battery rod for electronic atomization, the battery rod being configured to cooperate with an atomizer to realize the electronic atomization, and the battery rod comprising:
a housing, having a touch region, and the touch region being conductive;
at least one touch sensing electrode, located in the housing and arranged facing the touch region, the touch region and the at least one touch sensing electrode forming an inductive capacitor cooperatively;
a control chip, located in the housing, connected to the at least one touch sensing electrode, and configured to detect the capacitance value of the inductive capacitor and control the operations of the battery rod according to the change of the detected capacitance value of the inductive capacitor.

2. The battery rod according to claim 1, wherein the housing is made of a metal material, and the touch region is a portion of the outer surface of the housing facing the at least one touch sensing electrode.

3. The battery rod according to claim 1, wherein the housing comprises an insulative shell and a conductive layer arranged on the outer surface of the insulative shell, and the conductive layer is corresponding to the touch region.

4. The battery rod according to claim 1, wherein the housing comprises an insulative shell, a conductive layer arranged on the outer surface of the insulative shell, and a conductive layer arranged on the inner surface of the insulative shell;
the conductive layer arranged on the outer surface of the insulative shell and the conductive layer arranged on the inner surface of the insulative shell are corresponding to the touch region; and
the conductive layer arranged on the inner surface of the insulative shell serves as the at least one touch sensing electrode.

5. The battery rod according to claim 1, wherein the at least one touch sensing electrode is spaced apart from the touch region.

6. The battery rod according to claim 2 or 3, further comprising:
a circuit board, located in and insulated from the housing, and at least one selected from the group consisting of the at least one touch sensing electrode and the control chip being integrated on the circuit board.

7. The battery rod according to claim 1, wherein the at least one touch sensing electrode comprises a metal pad.

8. The battery rod according to claim 1, wherein the at least one touch sensing electrode comprises at least two touch sensing electrodes.

9. The battery rod according to claim 1, wherein the battery rod is configured in such a way that the capacitance value of the inductive capacitor is changeable as the touch region is touched.

10. An electronic atomization device, comprising an atomizer and the battery rod according to any one of claims 1-9;
wherein the battery rod is configured to supply power to the atomizer.
